# EUROPEAN PATENT SPECIFICATION

(11) **EP 4 293 135 B1**
(45) Date of publication and mention of the grant of the patent: **13.05.2026**
(21) Application number: 22752675.3
(22) Date of filing: 03.02.2022
(51) Int. Cl.: C23C 14/50, C23C 16/46, H01L 21/67, C23C 16/458, C23C 14/54

(54) **STAGE FOR HEATING AND COOLING OBJECT**
BÜHNE ZUM HEIZEN UND KÜHLEN EINES OBJEKTS
PLATINE DE CHAUFFAGE ET DE REFROIDISSEMENT D'OBJET

(30) Priority: 09.02.2021 JP 2021019397
(43) Date of publication of application: 20.12.2023
(73) Proprietor: Advantec Co., Ltd., Tokyo 1000005 (JP)
(72) Inventor: MASUDA, Yuji, Tokyo 100-0005 (JP)
(74) Representative: Pitchford, James Edward
(86) International application number: PCT/JP2022/004189
(87) International publication number: WO 2022/172848

(56) References cited:
- JP-A- 2004 108 614
- JP-A- 2007 180 091
- JP-A- H0 737 862
- JP-A- S6 285 411
- US-A1- 2007 056 953
- US-A1- 2007 090 516

## Description

### TECHNICAL FIELD

The present invention relates to a stage for heating and cooling an object.

### BACKGROUND ART

Japanese Patent No. 5427367 discloses a rectangular susceptor. Susceptors are used, for example, as stages in the manufacturing of semiconductor integrated circuits, flat display panels, and solar photovoltaic power generation panels. Susceptors heat substrates, for example, in manufacturing processes. At that time, it is required to heat the substrates rapidly and uniformly. It is also desirable that the substrates can be cooled. Therefore, it is conceivable to use a cooling tube and a heating tube for stage temperature control. In this case, when the tubes are simply in contact with the stage, there is a problem that the tubes may come out and the efficiency of temperature control will be lowered. On the other hand, in the case of inserting the tubes into the stage, there is a problem that the processing is difficult and no modification is feasible.

### CITATION LIST

### PATENT LITERATURE

Patent Literature 1: Japanese Patent No. 5427367

US 2007/056953 discloses a stage according to the prior art.

### SUMMARY OF INVENTION

### TECHNICAL PROBLEM

The present invention intends to provide a stage with a tube provided therein, in which the tube can be permanently in contact with the stage by a simple method and modifications can be facilitated.

### SOLUTION TO PROBLEM

The above-described problems can be solved by a stage that includes not only a heating part for heating a mount surface of the stage but also a cooling part. Further, the above-described problems can be solved by filling a clearance of a groove that accommodates the heating part or the cooling part with a heat conductive medium.

A first invention relates to a stage 1 installed in a chamber for heating and cooling an object. The stage 1 includes: a stage body 5 with a mount surface for mounting the object; a first tubular part 7 that causes a first fluid to flow for temperature adjustment of the mount surface; and a first tube support part 9 for supporting the first tubular part 7.

Further, the stage body 5 includes: a first groove part 11 for accommodating the first tubular part 7; and paired notches 13a and 13b facing each other across the first groove part 11.

Further, the first tube support part 9 includes a connection part 15 for connecting the paired notches 13a and 13b.

In a preferable example of this stage, a heat conductive medium exists in a clearance between the first tubular part 7 and the first groove part 11. A preferable example of the heat conductive medium is silver, grease, metal fiber, or gas.

As a preferable example of this stage, in the stage according to the first aspect of the invention, the first fluid is a fluid for raising a temperature of the mount surface. The stage further includes: a second tubular part 21 that causes a second fluid to flow for lowering a temperature of the mount surface; a second groove part 23 for accommodating the second tubular part 21; and a second tube support part 25 for supporting the second tubular part 23.

A second invention relates to a vacuum device that includes the above-described stage as a susceptor.

This vacuum device is used, for example, for manufacturing a semiconductor integrated circuit, a flat display panel, or a solar cell panel.

A third invention relates to a method for manufacturing a semiconductor integrated circuit, a flat display panel, or a solar cell panel using the above-described vacuum device.

### ADVANTAGEOUS EFFECTS OF INVENTION

The present invention can provide a stage including a groove part for accommodating a tubular part, paired notches facing each other across the groove part, and a tube support part including a connection part for connecting the paired notches. Therefore, a tube provided in the stage can be permanently in contact with the stage by a simple method, and modifications can be facilitated.

### BRIEF DESCRIPTION OF DRAWINGS

FIG. 1 is a conceptual diagram illustrating how a stage is installed.
FIG. 2 is a schematic diagram illustrating the stage.
FIG. 3 is a partial cross-sectional diagram illustrating the stage.
FIG. 4 is a conceptual diagram illustrating a connection part.
FIG. 5 is a reference diagram illustrating the stage during manufacturing.
FIG. 6 is a conceptual diagram illustrating an exemplary use of a heat conductive medium.
FIG. 7 is a photograph in lieu of a drawing showing a back surface of a stage on which grooves and notched parts are formed.
FIG. 8 is a photograph in lieu of a drawing showing how a tube support part is welded.

### DESCRIPTION OF EMBODIMENTS

Hereinafter, embodiments for carrying out the present invention will be described with reference to attached drawings. The present invention is not limited to the embodiments described below and encompasses appropriate modifications within the scope obvious to those skilled in the art from the following embodiments.

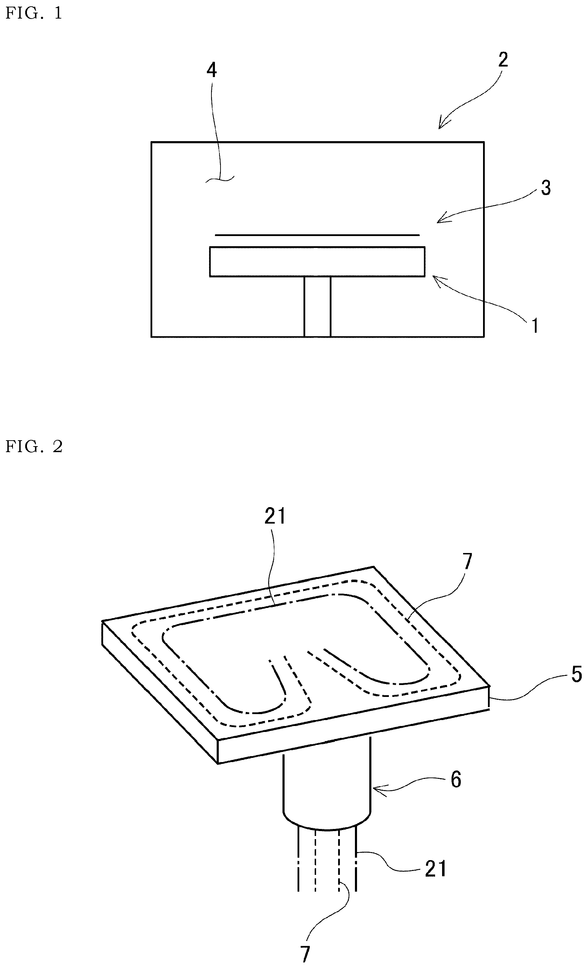

FIG. 1 is a conceptual diagram illustrating how a stage is installed. A stage 1 is usually installed inside a process chamber 2 to perform temperature management for a substrate 3. The process chamber 2 is isolated from the outside air and kept at a desired degree of vacuum. The process chamber 2 may be filled with a process gas 4 and kept under pressure. The pressure of the process gas 4 varies depending on the difference in type of the process chamber. There are different types of process chambers, such as physical vapor deposition (PVD) chambers, sputtering chambers, ion metal implantation (IMP) chambers, chemical vapor deposition (CVD) chambers, atomic layer deposition (ALD) chambers, plasma etching chambers, and annealing chambers.

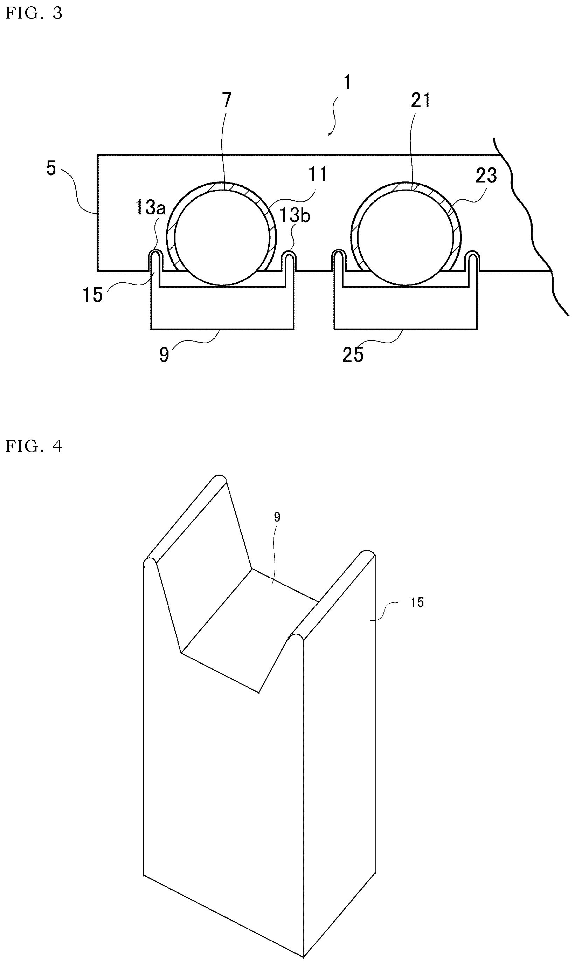

FIG. 2 is a schematic diagram illustrating the stage. FIG. 3 is a partial cross-sectional diagram illustrating the stage. The stage is a mount stand installed in the chamber for heating and cooling an object. A vacuum chamber is an exemplary chamber. Semiconductor integrated circuits, flat display panels, and solar photovoltaic power generation panels, or substrates in the process of manufacturing them are exemplary objects.

As illustrated in FIGS. 1 to 3, the stage 1 includes a stage body 5, a first tubular part 7, and a first tube support part 9. The stage body 5 includes a first groove part 11 and paired notches 13a and 13b. Further, the first tube support part 9 includes a connection part 15. A preferable example of the stage 1 further includes a second tubular part 21, a second groove part 23, and a second tube support part 25. According to the example illustrated in FIGS. 1 to 3, the tubular part is in communication, via the interior of a table support 6, with the outside of the chamber 2. Therefore, the fluid can flow into the tubular part from the outside.

### Stage Body 5

The stage body 5 is a portion including a mount surface for mounting an object.

### First Tubular Part 7

The first tubular part 7 is a tube that causes a first fluid to flow for temperature adjustment of the mount surface. It is preferable that the tubular part includes a material that does not melt when the stage 1 is heated. Appropriately causing a liquid for temperature adjustment to flow in this tube can adjust the temperature of the stage 1. The first tubular part 7 may be a portion configured by a cylindrical tube through which a liquid for cooling the stage 1 flows, for example. The tubular shape of the first tubular part 7 may be, for example, a tubular shape with a bottom surface being a circle having a radius of 5 mm. The radius in the above case may be not less than 3 mm and not greater than 9 mm or may be not less than 4 mm and not greater than 8 mm. The tube may be appropriately adjusted in largeness and length in consideration of the size of the stage 1. The radius of the first tubular part 7 may be uniform or may increase as the position shifts from an upstream side to a downstream side. The tubular shape of the first tubular part 7, in cross section, may be circular, elliptic, or rectangular (quadrangular, pentagonal, hexagonal, or octagonal). The first fluid may be a fluid for raising a temperature of the mount surface or may be a fluid for lowering a temperature. It is acceptable that fluids different in purpose of use flow in a single tube.

### First Tube Support Part 9

The first tube support part 9 is an element for supporting the first tubular part 7.

### First Groove Part 11

The first groove part 11 is provided in the stage body 5 and serves as an element for accommodating the first tubular part 7. The first groove part 11 may be provided on the mount surface side of the stage body 5, or may be provided on a back surface (a surface opposite to the mount surface) side. The groove part 11 is a portion lowered in height than its surroundings.

### Paired Notches 13a and 13b

The paired notches 13a and 13b are recessed portions provided at positions facing each other across the first groove part 11. The paired notches 13a and 13b can also be referred to as insertion holes that face each other across the first tubular part 7 and are provided on both sides of the first tubular part 7. The connection part 15 of the first tube support part 9 is insertable into these recessed portions, as described below. As a result, the first tube support part 9 can be fixed via the connection part 15. This causes the first tubular part 7 to be fixed in the first groove part 11. The holes of the paired notches 13a and 13b may be, for example, holes of about 30 mm elongated in the direction in which the tube of the tubular part extends. The holes of the paired notches 13a and 13b may be from 20 mm to 30 mm, may be not less than 21 mm and not greater than 35 mm, in depth. Providing the paired notches 13a and 13b, as a plurality of sets, on the back surface of the stage is preferable. The number of the paired notches 13a and 13b for one stage 1 may be, for example, three, four, or five. If the number of the paired notches 13a and 13b provided in the stage 1 is large, attaching a large number of connection parts 15 will be feasible. Therefore, the first tubular part 7 can be fixed more stably.

The distance from one hole of a set of paired notches 13a and 13b facing each other across a certain groove part 11 to one hole of neighboring paired notches 13a and 13b in the direction in which the tube of the first tubular part 7 extends may be not less than 70 mm and not greater than 100 mm, may be not less than 70 mm and not greater than 110 mm, may be not less than 80 mm and not greater than 100 mm, or may be not less than 80 mm and not greater than 110 mm, for example. The distance between the holes facing each other across the groove part 11, of the set of paired notches 13a and 13b, may be not less than 10 mm and not greater than 15 mm, may be not less than 12 mm and not greater than 15 mm, or may be not less than 15 mm and not greater than 20 mm, for example.

FIG. 4 is a conceptual diagram illustrating the connection part. The connection part 15 can be attached to the paired notches 13a and 13b of the stage 1 so as to cover the tubular part 7 and the groove part 11. The shape of the connection part 15 may be a shape obtainable by processing the shape of a quadrangular prism, for example, in such a manner that one bottom surface is recessed at a central portion thereof. In addition, the central portion is lower in height than peripheral bottom surfaces, and there are walls formed at both ends of this recessed portion. These walls may be protrusions. The height of this protrusion (wall) depends on the depth of the hole of the paired notches 13a and 13b, and may be not less than 10 mm and not greater than 13 mm or may be not less than 13 mm and not greater than 16 mm, for example.

The above-described walls are not required to have a surface facing a central region of the bottom surface and being perpendicular to the bottom surface. The above-described portion of the wall may extend from the central region of the bottom surface of the quadrangular prism in a direction of opening toward the opposite side of the bottom surface. For example, the angle between one of the above protrusions (walls) and an opposing protrusion (wall) may be not less than 30 degrees and not greater than 40 degrees, may be not less than 40 degrees and not greater than 50 degrees, or may be not less than 50 degrees and not greater than 60 degrees.

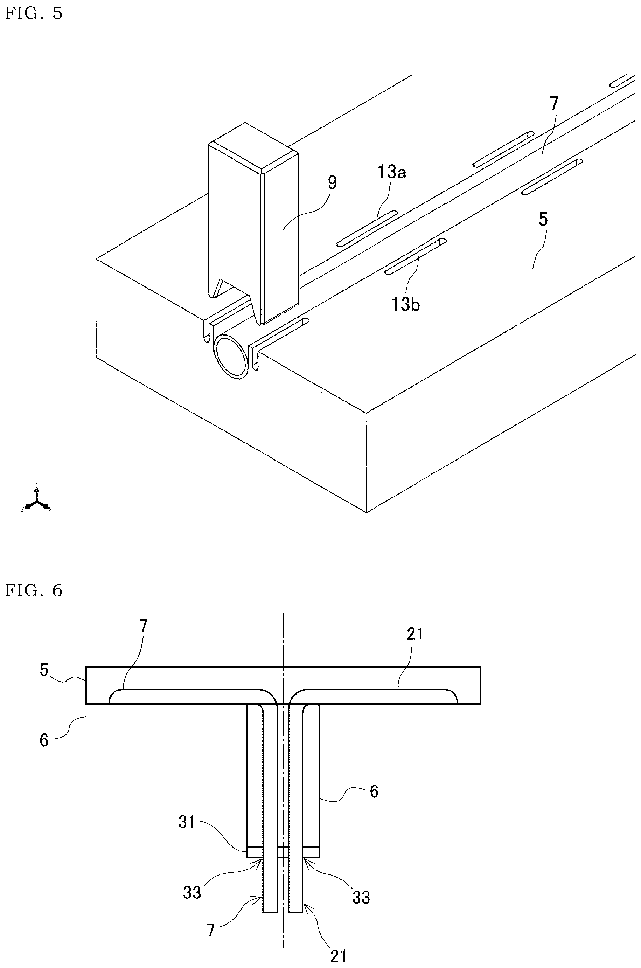

FIG. 5 is a reference diagram illustrating the stage during manufacturing.

A preferable example of the stage includes a heat conductive medium existing in a clearance between the first tubular part 7 and the first groove part 11. Silver, grease, metal fiber, or gas is a preferable example of the heat conductive medium.

FIG. 6 is a conceptual diagram illustrating an exemplary use of the heat conductive medium. Microscopically, there is a minute clearance between the first tubular part 7 and the first groove part 11. Therefore, using the heat conductive medium is effective. Conceivable examples of the heat conductive medium include solids such as carbon fiber, grease-like materials, liquids such as silver, and gases such as hydrogen and helium. In order to prevent the run-off, it is feasible to provide sealing in the case of using the grease-like materials, liquids, and gases.

When the heat conductive medium is a fluid such as a grease-like material, a liquid, or a gas, it is desirable to fill the clearance with the heat conductive medium and prevent the leakage by tight closure. In a simplified example, a sealing plate 31 is attached to an end of the table support 6, the first tubular part 7 and the second tubular part 21 are completely sealed by a sealing part 33. Sealing the heat conductive medium realizes isolation from the atmosphere and prevention of the run-off. When the heat conductive medium is gaseous, filling the clearance with the gas of pressurized state can sharply increase the heat conduction efficiency.

In a preferable example of the stage, the first fluid is a fluid for raising a temperature of the mount surface. The stage further includes the second tubular part 21 causing the second fluid to flow for lowering a temperature of the mount surface, the second groove part 23 for accommodating the second tubular part 21, and the second tube support part 25 for supporting the second tubular part 23. In this case, the first tubular part functions as a heating part. Further, the second tubular part functions as a cooling part.

A second aspect of the present invention relates to a vacuum device including any one of the above-described stages as a susceptor. This vacuum device is, for example, a vacuum device used for manufacturing a semiconductor integrated circuit, a flat display panel, or a solar cell panel. The vacuum device usually includes a chamber and a vacuum pump that evacuates the chamber. Further, the vacuum device may include an introduction part for introducing various samples into the chamber. Further, the vacuum device may appropriately include sensors and measurement devices for performing various measurements. A process chamber for manufacturing objects is an exemplary chamber. Examples of the flat display panel include organic EL displays, plasma displays, and liquid crystal displays.

A third aspect of the present invention relates to a method for manufacturing a semiconductor integrated circuit, a flat display panel, or a solar cell panel, which uses the above-described vacuum device. Methods for manufacturing semiconductor integrated circuits are conventionally known as described in Japanese Patent No. 3956697, Japanese Patent No. 3519589, and Japanese Patent No. 3064993, for example. Methods for manufacturing flat display panels are conventionally known as described in Japanese Patent No. 5173757, Japanese Patent No. 5169757, and Japanese Patent No. 4604752, for example. Methods for manufacturing solar cell panels are conventionally known as described in Japanese Patent No. 6555964, Japanese Patent No. 6498053, and Japanese Patent No. 5386044, for example.

The stage can be manufactured, for example, in the following manner. The manufacturing includes machining a groove (a flow channel) on an aluminium plate having a thickness of 30 to 100 mm, which is a rectangular (for example, square) plate with one side length of 1500 to 4000 mm. Further, the manufacturing includes appropriately forming paired notches on both sides of the groove. The material of the stage body is not limited to aluminium and may be any other metal. The manufacturing further includes inserting a stainless-steel pipe into the groove (flow channel) thus obtained. Following the insertion of the pipe into the groove, the tube support part is inserted into the paired notches. The tube support part may be optionally welded. The stage can be manufactured in this manner.

### Practical Example

Manufacturing of the susceptor was implemented in the following manner. A flow channel was processed in an aluminium plate of material A6061. Temperature control was performed with a heater or a flowing heat conductive medium. The stage (susceptor) is normally used in a vacuum device. However, for the purpose of temperature change measurement, the temperature change was measured in the atmosphere in this example.

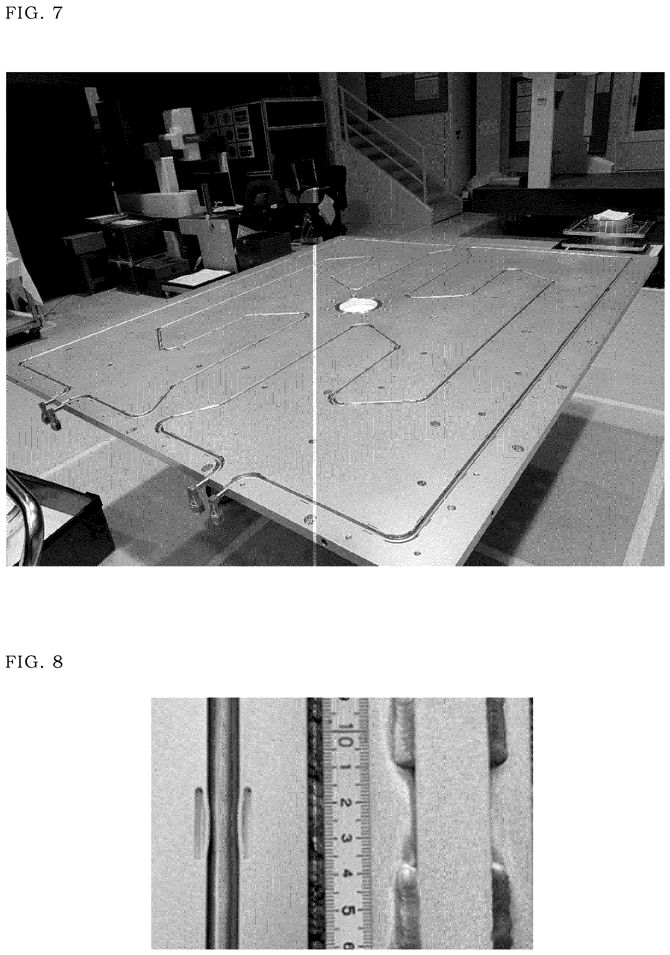

FIG. 7 is a photograph in lieu of a drawing showing a back surface of a stage on which grooves and notched parts are formed. FIG. 8 is a photograph in lieu of a drawing showing how the tube support part is welded.

## Claims

1. A stage (1) installed in a chamber for heating and cooling an object, the stage (1) comprising:
a stage body (5) with a mount surface for mounting the object;
a first tubular part (7) that causes a first fluid to flow for temperature adjustment of the mount surface; and
a first tube support part (9) for supporting the first tubular part (7), wherein
the stage body (5) includes:
a first groove part (11) for accommodating the first tubular part (7); and
paired notches (13a and 13b) facing each other across the first groove part (11), and
the first tube support part (9) includes
a connection part (15) for connecting the paired notches (13a and 13b),
the first fluid is a fluid for raising a temperature of the mount surface,
the stage body (5) further includes:
a second tubular part (21) that causes a second fluid to flow for lowering a temperature of the mount surface;
a second groove part (23) for accommodating the second tubular part (21); and
a second tube support part for supporting the second tubular part (21), the second tube support part being separate from the first tube support part (9),
the stage body (5) includes
second paired notches facing each other across the second groove part (23), and
the second tube support part includes
a second connection part (25) for connecting the second paired notches.

2. The stage according to claim 1, wherein a heat conductive medium exists in a clearance between the first tubular part (7) and the first groove part (11).

3. The stage according to claim 2, wherein the heat conductive medium is silver, grease, metal fiber, or gas.

4. A vacuum device comprising the stage according to any one of claims 1 to 3 as a susceptor.

5. The vacuum device according to claim 4, which is used for manufacturing a semiconductor integrated circuit, a flat display panel, or a solar cell panel.

6. A method for manufacturing a semiconductor integrated circuit, a flat display panel, or a solar cell panel using the vacuum device according to claim 4.

7. The stage according to claim 1, wherein
the connection part (15) includes:
a quadrangular prism-shaped body part;
a flat surface part centrally located on an upper surface of the body part; and
two walls existing on both sides of the flat surface part, the two walls correspond to the paired notches (13a and 13b), the second connection part (25) includes:
a second body part having a quadrangular prism shape;
a second flat surface part centrally located on an upper surface of the second body part; and
two second walls existing on both sides of the second flat surface part, and
the two second walls correspond to the second paired notches.

## Patentansprüche

1. Tisch (1), installiert in einer Kammer zum Erwärmen und Kühlen eines Objekts, wobei der Tisch (1) Folgendes umfasst:
einen Tischkörper (5) mit einer Montagefläche zum Montieren des Objekts;
ein erstes röhrenförmiges Teil (7), das ein erstes Fluid zur Temperaturjustierung der Montagefläche zum Fließen bringt; und
ein erstes Rohrtragteil (9) zum Tragen des ersten röhrenförmigen Teils (7), wobei
der Tischkörper (5) Folgendes umfasst:
ein erstes Nutteil (11) zum Aufnehmen des ersten röhrenförmigen Teils (7); und
gepaarte Kerben (13a und 13b), die einander über das erste Nutteil (11) hinweg zugewandt sind, und
das erste Rohrtragteil (9) Folgendes umfasst:
ein Verbindungsteil (15) zum Verbinden der gepaarten Kerben (13a und 13b),
das erste Fluid ein Fluid zum Erhöhen einer Temperatur der Montagefläche ist,
der Tischkörper (5) ferner Folgendes umfasst:
ein zweites röhrenförmiges Teil (21), das ein zweites Fluid zum Senken der Temperatur der Montagefläche fließen lässt;
ein zweites Nutteil (23) zum Aufnehmen des zweiten röhrenförmigen Teils (21); und
ein zweites Rohrtragteil zum Tragen des zweiten röhrenförmigen Teils (21), wobei das zweite Rohrtragteil vom ersten Rohrtragteil (9) getrennt ist,
der Tischkörper (5) Folgendes umfasst:
zweite gepaarte Kerben, die einander über das zweite Nutteil (23) hinweg zugewandt sind, und
das zweite Rohrtragteil Folgendes umfasst:
ein zweites Verbindungsteil (25) zum Verbinden der zweiten gepaarten Kerben.

2. Tisch nach Anspruch 1, wobei sich ein wärmeleitendes Medium in einem Freiraum zwischen dem ersten röhrenförmigen Teil (7) und dem ersten Nutteil (11) befindet.

3. Tisch nach Anspruch 2, wobei das wärmeleitende Medium Silber, Fett, Metallfaser oder Gas ist.

4. Vakuumvorrichtung, die den Tisch nach einem der Ansprüche 1 bis 3 als Suszeptor umfasst.

5. Vakuumvorrichtung nach Anspruch 4, die zur Herstellung einer integrierten Halbleiterschaltung, eines Flachbildschirms oder eines Solarzellenpanels verwendet wird.

6. Verfahren zur Herstellung einer integrierten Halbleiterschaltung, eines Flachbildschirms oder eines Solarzellenpanels unter Verwendung der Vakuumvorrichtung nach Anspruch 4.

7. Tisch nach Anspruch 1, wobei
das Verbindungsteil (15) Folgendes umfasst:
ein vierkantiges prismatisches Körperteil;
ein flaches Oberflächenteil, das mittig auf einer Oberseite des Körperteils angeordnet ist; und
zwei Wände, die auf beiden Seiten des flachen Oberflächenteils vorhanden sind,
die beiden Wände den gepaarten Kerben (13a und 13b) entsprechen,
das zweite Verbindungsteil (25) Folgendes umfasst:
ein zweites Körperteil mit einer viereckigen Prismenform;
ein zweites flaches Oberflächenteil, das mittig auf einer Oberseite des zweiten Körperteils angeordnet ist; und
zwei zweite Wände, die auf beiden Seiten des zweiten flachen Oberflächenteils vorhanden sind, und
die beiden zweiten Wände den zweiten gepaarten Kerben entsprechen.

## Revendications

1. Platine (1) installée dans une chambre pour chauffer et refroidir un objet, la platine (1) comprenant :
un corps de platine (5) avec une surface de montage pour monter l'objet ;
une première partie tubulaire (7) qui fait circuler un premier fluide pour ajuster la température de la surface de montage ; et
une première partie de support de tube (9) pour supporter la première partie tubulaire (7), dans laquelle
le corps de platine (5) comporte :
une première partie rainurée (11) destinée à recevoir la première partie tubulaire (7) ; et
des encoches appariées (13a et 13b) se faisant face de part et d'autre de la première partie rainurée (11), et
la première partie de support de tube (9) comporte
une partie de liaison (15) pour relier les encoches appariées (13a et 13b),
le premier fluide est un fluide permettant d'augmenter une température de la surface de montage,
le corps de platine (5) comporte en outre :
une seconde partie tubulaire (21) qui fait circuler un second fluide pour abaisser une température de la surface de montage ;
une seconde partie rainurée (23) destinée à recevoir la seconde partie tubulaire (21) ; et
une seconde partie de support de tube pour supporter la seconde partie tubulaire (21), la seconde partie de support de tube étant séparée de la première partie de support de tube (9),
le corps de platine (5) comporte
de secondes encoches appariées se faisant face de part et d'autre de la seconde partie rainurée (23), et
la seconde partie de support de tube comporte
une seconde partie de liaison (25) pour relier les secondes encoches appariées.

2. Platine selon la revendication 1, dans laquelle un milieu conducteur de chaleur existe dans un espace entre la première partie tubulaire (7) et la première partie rainurée (11).

3. Platine selon la revendication 2, dans laquelle le milieu conducteur de chaleur est de l'argent, de la graisse, de la fibre métallique, ou du gaz.

4. Dispositif à vide comprenant la platine selon l'une quelconque des revendications 1 à 3 en tant que suscepteur.

5. Dispositif à vide selon la revendication 4, qui est utilisé pour la fabrication d'un circuit intégré à semi-conducteur, d'un panneau d'affichage plat, ou d'un panneau photovoltaïque.

6. Procédé de fabrication d'un circuit intégré à semi-conducteur, d'un panneau d'affichage plat, ou d'un panneau photovoltaïque à l'aide du dispositif à vide selon la revendication 4.

7. Platine selon la revendication 1, dans laquelle
la partie de liaison (15) comporte :
une partie de corps en forme de prisme quadrangulaire ;
une partie de surface plane située au centre de la surface supérieure de la partie de corps ; et
deux parois existant de part et d'autre de la partie de surface plane,
les deux parois correspondent aux encoches appariées (13a et 13b),
la seconde partie de liaison (25) comporte :
une seconde partie de corps ayant une forme de prisme quadrangulaire ;
une seconde partie de surface plane située au centre sur la surface supérieure de la seconde partie de corps ; et
deux secondes parois existant de part et d'autre de la seconde partie de surface plane, et
les deux secondes parois correspondent aux secondes encoches appariées.
